Europäisches Patentamt

European Patent Office

Office européen des brevets

(11) Veröffentlichungsnummer: **0 501 536 A2**

# (12) EUROPÄISCHE PATENTANMELDUNG

(21) Anmeldenummer: **92200183.9**

(22) Anmeldetag: **18.01.92**

(51) Int. Cl.5: **H04N 5/50**

(30) Priorität: **29.01.91 DE 4102562**

(43) Veröffentlichungstag der Anmeldung:
**02.09.92 Patentblatt 92/36**

(84) Benannte Vertragsstaaten:
**PT**

(71) Anmelder: **Deutsche Thomson-Brandt GmbH**
**Postfach 2060**
**W-7730 Villingen-Schwenningen(DE)**

(72) Erfinder: **Koblitz, Rudolf**
**J.J. Rieggerstrasse 12a**
**W-7730 Villingen(DE)**
Erfinder: **Roth, Sabine**
**Auf der Wanne 67**
**W-7730 Villingen(DE)**
Erfinder: **Rieger, Martin**
**Alte Strasse 14**
**W-7210 Rottweil-Neukirch(DE)**

(54) **Verfahren und Schaltung für eine automatische, hochpräzise Frequenz-Feinabstimmung.**

(57) 1. Verfahren und Schaltung für eine automatische, hochpräzise Frequenz-Feinabstimmung.

2.1 Bekannte analoge automatische Frequenz-Feinabstimmungs-Systeme sind unpräzise und z.B. aufgrund eines erforderlichen Schwingkreises nicht vollständig integrierbar. Bekannte digitale automatische Frequenz-Feinabstimmungs-Systeme können zwar hochpräzise sein, erfordern aber eine vergleichsweise hohe Chip-Fläche und einen erhöhten Stromverbrauch.

2.2 Zum Zweck einer hochpräzisen Frequenz-Feinabstimmung, z.B. auf einen bestimmten Fernsehkanal, wird eine frequenzabgleichbare Analog-Schaltung, z.B. ein FM-Demodulator, in einem integrierten Schaltkreis mit Hilfe eines Steuerstromes abgeglichen. Der in einer Regelschleife erzeugte Steuerstrom ist von einer Bezugsfrequenz entsprechender Genauigkeit und von einer auf dem Chip integrierten Referenz-Kapazität abhängig. Nach einer Frequenzwahl wird die Analog-Schaltung kalibriert und anschließend in einem Meß-Mode die Frequenz feinabgestimmt. Danach arbeitet die Analog-Schaltung im Normal-Mode.

2.3 Analoge Schaltung für hochpräzise, automatische Frequenz-Feinabstimmung.

FIG.2

EP 0 501 536 A2

Die Erfindung betrifft ein Verfahren und eine Schaltung für eine automatische, hochpräzise Frequenz-Feinabstimmung mit Hilfe einer frequenzabgleichbaren Analog-Schaltung in einem integrierten Schaltkreis.

Stand der Technik

Im Bereich der elektronischen Signalverarbeitung ist es häufig erforderlich, Frequenzen oder frequenzabhängige Schaltungen genau abzugleichen, z.B. beim Abstimmen von Tunern oder beim Abgleich von Frequenzgeneratoren.
Entsprechende AFT-Verfahren (automatic fine tune, automatische Feinabstimmung) sind z.B. aus "Television Engineering Handbook", Seite 13.117, K.Blair Benson, McGraw-Hill Book Company, bekannt. Dabei wird die Phasenverschiebung an einem Parallelschwingkreis ausgewertet.

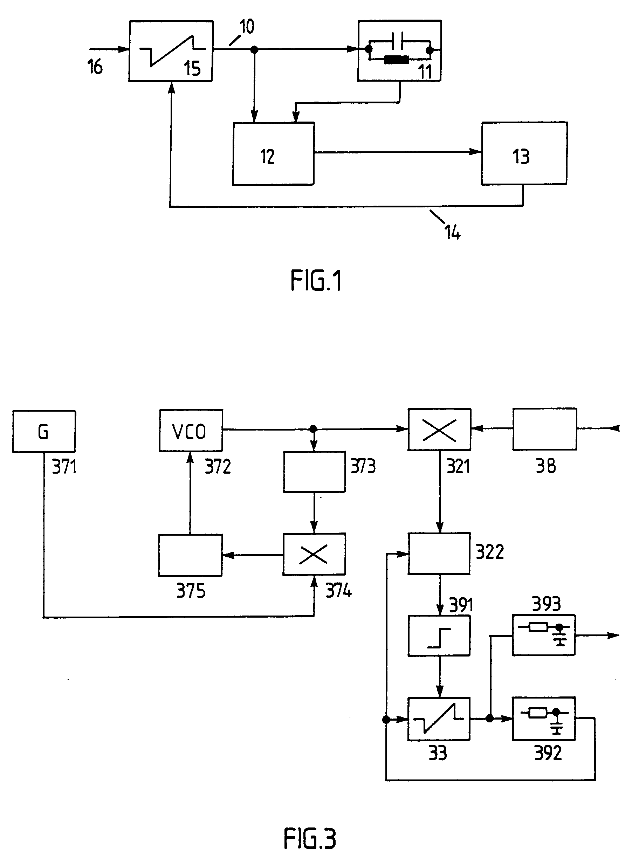

Fig. 1 zeigt ein entsprechendes Blockschaltbild. Ein von einer Abstimmung beeinflußtes Ausgangssignal 10, z.B. ein Fernsehton-Signal, wird einer Schwingkreisschaltung 11 und einem ersten Eingang eines Phasen-Detektors 12 zugeführt.
Die Schwingkreisschaltung ist auf eine Soll-Frequenz abgestimmt. Das Ausgangssignal der Schwingkreisschaltung 11 wird einem zweiten Eingang des Phasen-Detektors zugeführt. Das Ausgangssignal des Phasen-Detektors wird in einem Tiefpaß 13 gefiltert und dient als Regelgröße 14 für die Abstimmung des Eingangssignals 10. Eine dafür geeignete Schaltung ist z.B. ein durch eine Regelgröße abstimmbarer FM-Demodulator 15, dem die Regelgröße 14 und ein zu demodulierendes Signal 16 zugeleitet werden.
In diesem Anwendungsfall ist mit dem Stand der Technik aber nur eine Abstimmungsgenauigkeit von etwa 150kHz erreichbar. Außerdem sind solche bekannten AFT-Schaltungen nicht vollständig integrierbar. Es werden z.B. zwei Anschlüsse an einem integrierten Schaltkreis für einen externen Schwingkreis benötigt.

Eine weitere bekannte Lösung besteht darin, die abzustimmende Frequenz digital zu zählen und entsprechend nachzuregeln. Der dazu benötigte Schaltungsaufwand und eine dementsprechende Chipfläche in einem integrierten Schaltkreis sind aber hoch. Der Stromverbrauch für eine solche digitale AFT-Schaltung ist vergleichsweise ebenfalls hoch.

Erfindung

Der Erfindung liegt die Aufgabe zugrunde, ein Verfahren zur automatischen, hochpräzisen Frequenz-Feinabstimmung mit geringem Schaltungsaufwand und Stromverbrauch in integrierten Schaltkreisen anzugeben.

Im Prinzip besteht das erfindungsgemäße Verfahren darin, daß zum Zweck einer automatischen, hochpräzisen Frequenz-Feinabstimmung, z.B. auf einen bestimmten Fernsehkanal, für eine frequenzabgleichbare Analog-Schaltung in einem integrierten Schaltkreis in Abhängigkeit von einer hochpräzisen Bezugsfrequenz mindestens eine Regelgröße für die frequenzabgleichbare Analog-Schaltung gebildet und gespeichert wird, deren Wert ebenfalls von einem Referenz-Schaltungsteil in dem integrierten Schaltkreis beeinflußt wird, und daß für die Feinabstimmung nacheinander verschiedene Betriebsarten eingeschaltet werden.
Vorteilhafte Weiterbildungen des erfindungsgemäßen Verfahrens ergeben sich aus den Unteransprüchen 2 bis 7.
Der Erfindung liegt die weitere Aufgabe zugrunde, eine Schaltung für das erfindungsgemäße Verfahren anzugeben.
Im Prinzip ist die erfindungsgemäße Schaltung versehen mit einer mit einer Regelgröße frequenzabgleichbaren Analog-Schaltung 23, 33, mit einem Einspeisepunkt für eine hochpräzise Bezugsfrequenz $f_{ch}$, mit einem ersten, zweiten und dritten Umschalter, mit einem ersten T1, zweiten T2 und dritten T3 Regelverstärker, mit einem ersten CL und einem zweiten CH Komparator, mit einem Summierer 21 und mit einem internen Kondensator $C_{int}$, wobei zugeführt wird:

- eine Ausgangsspannung $V_1$ der Analog-Schaltung 23 zweiten Eingängen des ersten T1 und zweiten T2 Regelverstärkers und des ersten CL und zweiten CH Komparators;
- eine Referenzspannung $V_{ref}$ einem ersten Eingang 251 des ersten Regelverstärkers T1 in einem Normal-Mode;
- eine kombinierte Spannung aus der Referenzspannung $V_{ref}$ und einer Kompensationsspannung $V_{of}$ einem ersten Eingang 252 des zweiten Regelverstärkers T2 in einem Kalibrier-Mode;
- eine Differenzspannung aus der Referenzspannung $V_{ref}$ undeiner Schwellspannung $V_{th}$ einem ersten Eingang 254 des ersten Komparators CL und eine Summenspannung aus der Referenzspannung $V_{ref}$ und der Schwellspannung $V_{th}$ einem ersten Eingang 253 des zweiten Komparators CH in einem Meß-Mode;
- ein Ausgangssignal des ersten Regelverstärkers T1 einem ersten Eingang N des dritten Umschalters im Normal-Mode;
- ein Ausgangssignal des zweiten Regelverstärkers T2 einem dritten Eingang C des dritten Umschalters im Kalibrier-Mode;
- ein Ausgangssignal des dritten Umschalters einem Eingang des dritten T3 Regelverstärkers;

- ein Ausgangssignal des dritten T3 Regelverstärkers einem ersten Eingang des Summierers 21;
- ein von der Größe des internen Kondensators $C_{int}$ abgeleitetes und mit einem Faktor k umgeformtes Signal einem zweiten Eingang des Summierers 21;
- ein Ausgangssignal des Summierers 21 einem Steuereingang der Analog-Schaltung 23;
- ein in der Analog-Schaltung 23 zu verarbeitendes Nutzsignal einem ersten Eingang N des ersten Umschalters im Normal-Mode;
- eine Zusatzsignal-Frequenz einem zweiten Eingang C, M des ersten Umschalters im Kalibrier- und im Meß-Mode;
- die hochpräzise Bezugsfrequenz $f_{ch}$ oder eine davon abgeleitete Frequenz einem ersten Eingang C des zweiten Umschalters im Kalibrier-Mode;
- eine vom Ausgangssignal des ersten Umschalters abgeleitete Signalfrequenz einem zweiten Eingang N, M des zweiten Umschalters;
- ein Ausgangssignal des zweiten Umschalters der AnalogSchaltung 23.

Die Ausgangssignale des ersten und des zweiten Komparators können dann z.B. dazu verwendet werden, einen Oszillator in einem Fernsehgeräte-Tuner abzustimmen.

Vorteilhafte Weiterbildungen der erfindungsgemäßen Schaltung ergeben sich aus den Unteransprüchen 9 bis 11.

Das Verfahren ist für integrierte Schaltkreise geeignet und ermöglicht eine automatische Frequenz-Feinabstimmung unter Verwendung von frequenzabgleichbaren Analog-Schaltungen, beispielsweise FM-Demodulatoren oder Frequenz-Generatoren. Die erfindungsgemäße AFT-Schaltung enthält eine automatisch arbeitende Regelschleife mit einer darin gebildeten Regelgröße. Diese Regelgröße wird zusätzlich von einem Referenz-Bauelement, z.B. einer Referenz-Kapazität, auf dem Substrat des integrierten Schaltkreises beeinflußt, wobei in einem jeweiligen Wert dieses Referenz-Bauelementes Fertigungstoleranzen bei der Herstellung des integrierten Schaltkreises ihren Ausdruck finden. Als Referenz wird der AFT-Schaltung in einem Kalibrier-Mode eine Bezugs-Frequenz mit der erforderlichen Genauigkeit zugeführt. Es sind dabei drei Betriebsarten vorgesehen, um die AFT-Funktion durchführen zu können:

    a) Normal-Mode,
    b) Kalibrier-Mode,
    c) Meß-Mode.

Im Kalibrier-Mode wird zunächst die Analog-Schaltung frequenzabgeglichen. Dieser Abgleich bleibt dann bis zu einem erneuten Einschalten des Kalibrier-Modes erhalten. Im Meß-Mode wird danach ein aktueller Wert einer feinabzustimmenden Frequenz mit Hilfe der zuvor abgeglichenen Analog-Schaltung ermittelt. Jenachdem, ob dieser ermittelte Wert kleiner, gleich oder größer als ein Sollwert für die feinabzustimmende Frequenz ist, findet dann eine entsprechende Feinabstimmung statt. Anschließend wird der Normal-Mode eingeschaltet, in dem die Analog-Schaltung für ihre eigentliche Aufgabe genutzt wird.

Vorteilhaft wird der Abgleich und die Feinabstimmung stromgesteuert unter Verwendung eines Speicherkondensators und von Transkonduktanzverstärkern.

Zeichnungen

Anhand der Zeichnungen werden Ausführungsbeispiele der Erfindung beschrieben. Die Zeichnungen zeigen in:

    Fig. 1     eine bekannte AFT-Schaltung;
    Fig. 2     eine erfindungsgemäße AFT-Schaltung;
    Fig. 3     die Anwendung der erfindungsgemäßen AFT-Schaltung in einer erweiterten integrierten Schaltung für Fernsehgeräte.

Ausführungsbeispiele

Im folgenden werden zunächst drei Betriebsarten der AFT-Schaltung für den Abgleich eines FM-Demodulators und für die Generierung von Signalen zur Feinabstimmung beschrieben. Wenn z.B. ein Fernsehgerät eingeschaltet oder der Empfangskanal in diesem Fernsehgerät gewechselt wird, wird zunächst kurzzeitig der Kalibrier-Mode gewählt (diese Wahl und die Wahl der anderen Betriebsarten geschieht vorteilhaft automatisch). Dabei wird der FM-Demodulator mit Hilfe einer präzisen Referenzfrequenz, z.B. der Farbträgerfrequenz, durch eine Regelgröße feinabgeglichen und ein Maß für diese Regelgröße gespeichert.

Anschließend wird kurzzeitig der Meß-Mode gewählt. Anhand der Ausgangsspannung des zuvor abgeglichenen FM-Demodulators detektieren zwei Komparatoren, ob die ZF-Frequenz und damit die Frequenz des Tuner-Oszillators beibehalten, vermindert oder vergrößert werden muß.

Nachdem der Tuner-Oszillator abgeglichen worden ist, wird der Normal-Mode eingeschaltet.

1. Normal-Mode

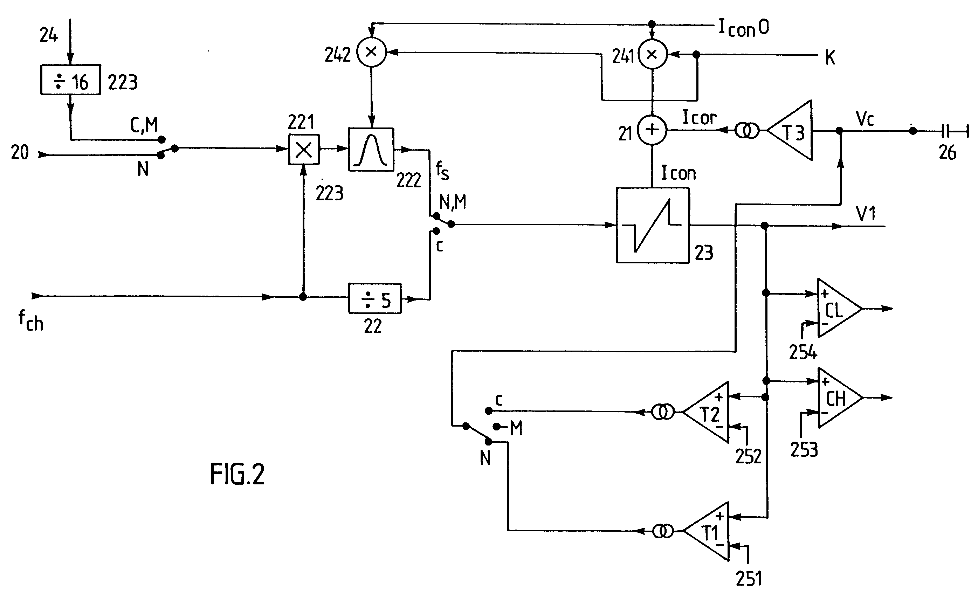

In Fig. 2 entspricht die Schalterstellung "N" dieser Betriebsart. Die Gesamtschaltung arbeitet als FM-Demodulator mit automatischem Abgleich der Mittenfrequenz. Als Signalquelle dient beispielsweise das ZF-Ausgangs-Tonsignal 20 eines 4.5MHz-Bandpaßfilters. Dieses Ausgangssignal wird in einem Mischer 221, dem ebenfalls die Frequenz $f_{ch}$ = 3.579545-MHz eines Farbträger-Oszillators zugeführt wird, auf 920kHz umgesetzt, in einem Filter 222 mit der Güte Q = 3 bandpaßgefiltert und bildet dann das Eingangssignal $f_s$, welches in einem FM-Demodulator 23 demoduliert wird.

Der FM-Demodulator 23 enthält einen internen, stromgesteuerten Oszillator (nicht dargestellt) mit einer Freilauf-Frequenz

$$f_1 = k_d * I_{con}/C_{int}, \qquad (1)$$

wobei $k_d$ eine erste Konstante, $I_{con}$ der Steuerstrom für den FM-Demodulator 23 und

$$C_{int} = C_{nom} \pm \Delta C \qquad (2)$$

ein auf der Schaltung integrierter, interner Kondensator (nicht dargestellt) mit einem Nennwert von $C_{nom}$ und einer absoluten Fertigungs-Toleranz von $\pm \Delta C$ ist.

Die Freilauffrequenz des Oszillators und damit die Abstimmung des FM-Demodulators kann auf die Frequenz des Eingangssignals $f_s$ synchronisiert werden, falls

$$|f_s - f_1| \leq \Delta f_1, \qquad (3)$$

mit $\Delta f_1$ = Synchronisier-Bereich.

Wenn das Eingangssignal $f_s$ frequenzmoduliert ist, gilt

$$f_s = f_c + \Delta f_s(t), \qquad (4)$$

wobei $f_c$ die Mittenfrequenz und $\Delta f_s$ der Hub ist. Für die Frequenz $f'_1$ des synchronisierten Oszillators gilt $f'_1 = f_s$, solange $\Delta f_s \leq \Delta f_1$. Dann stellt die tiefpaßgefilterte Ausgangsspannung $V_1$ das demodulierte Tonsignal dar,

$$V_1 = -k_f * (f_1 - f_c) + V_{ref}, \qquad (5)$$

wobei $k_f$ die Steilheit der Demodulatorkennlinie und $V_{ref}$ eine Referenzspannung ist.

In der AFT-Schaltung in Fig. 2 soll zum besseren Verständnis zunächst kein ZF-Ausgangs-Tonsignal 20 anliegen. Ein erster Transkonduktanz-Verstärker $T_1$, ein Speicherkondensator $C_{stor}$, ein dritter Transkonduktanz-Verstärker $T_3$ und der FM-Demodulator 23 bilden eine Abgleich-Schleife. Dem Eingang 251 des ersten Transkonduktanzverstärkers wird die Referenzspannung $V_{ref}$ zugeführt. Wenn zwischen der Mittenfrequenz $f_c$ und der Freilauf-Frequenz $f_1$ eine Frequenzdifferenz im Bereich

$$0 \leq |f_1 - f_c| \leq \Delta f_1 \qquad (6)$$

auftritt, korrigiert die automatische Abgleich-Schleife die Freilauf-Frequenz $f_1$ zu $f_1 = f_c$ in der folgenden Weise:
Wenn die Ausgangs-Spannung $V_1$ sich entsprechend Gleichung (5) ändert, lädt der erste Transkonduktanz-Verstärker $T_1$ (dieser hat eine Transkonduktanz $k_1$) mit einem maximalen Ausgangsstrom von z.B. $\pm 0.5\mu$A einen externen Speicherkondensator 26 ($C_{stor}$) auf eine Speicherspannung

$$V_c = (V_1 - V_{ref}) * k_1/(p * C_{stor}), \qquad (7)$$

wobei p die komplexe Frequenz ist. Entsprechend der Speicherspannung $V_c$ erzeugt der dritte Transkonduktanzverstärker $T_3$ (dieser hat eine Transkonduktanz $k_3$) einen Korrekturstrom

$$I_{cor} = k_3 * V_c, \qquad (8)$$

der in einem Summierer 21 zu einem, z.B. Fertigungstoleranzen berücksichtigenden, Steuerstrom $I_{conO}$ addiert wird und dann den Demodulator-Steuerstrom

$$I_{con} = k * I_{conO} + I_{cor} \qquad (9)$$

bildet. Der Steuerstrom $I_{conO}$ kann auch zum Abgleich des Filters 222 dienen. Ein erster 241 und ein zweiter 242 Multiplizierer multiplizieren dabei den Steuerstrom $I_{conO}$ im Normal-Mode mit einem Faktor k = 1.
Aus den Gleichungen (1), (2), (5) und (7) bis (9) enthält man durch entsprechende Umformung die korrigierte Freilauf-Frequenz

$$f_{1c} = k_d/(C_{nom} \pm \Delta C) * [I_{conO} - k_3 * k_1 * k_f * (f_1 - f_c)/(p * C_{stor})]. \qquad (10) \ (10)$$

Typische Werte sind $k_d$ = 1, $f_s$ = 920kHz, $C_{int}$ = $C_{nom}$ = 10pF, $I_{con}$ = $I_{conO}$, $f_1$ = $f_s$, $V_1$ = $V_{ref}$, $C_{stor}$ = 1nF.

Die Grenzfrequenz in der Abgleich-Schleife liegt bei 20Hz, um zu vermeiden, daß Tonsignal-Anteile im Korrekturstrom $I_{cor}$ Verzerrungen erzeugen.

Der Korrekturstrom $I_{cor}$ kann vorteilhaft auch ausgenutzt werden, um das Filter 222 abzustimmen, z.B. durch Verwendung eines zweiten Summierers oder durch direkte Zuführung des Demodulator-Steuerstromes $I_{con}$ zu diesem Filter (nicht dargestellt).

Das Signal/Rausch-Verhältnis des FM-Demodulators 23 ist etwa umgekehrt proportional zum Synchronisier-Bereich $\Delta f_1$. Darum sollte $\Delta f_1$ so klein wie möglich gemacht werden.

Falls die automatische Ableich-Schleife nicht benutzt wird und $I_{corO}$ anstelle von Korrekturstrom $I_{cor}$ ein konstanter Strom unabhängig vom Absolutwert des internen Kondensators $C_{int}$ ist, kann man aus den Gleichungen (1) und (2) erkennen, daß die Freilauf-Frequenz $f_1$ von der absoluten Toleranz $\Delta C$ abhängt. Diese Toleranz hat eine Größe von etwa ±15%.

Unter diesen Bedingungen und um noch eine gute Synchronisierung sicherzustellen, sollte $\Delta f_1$ einen minimalen Wert von

$$\Delta f_1 = \Delta f_s + (\Delta C/C_{nom})^* f_c \qquad (11)$$

nicht unterschreiten.

Ein vorteilhafter Wert für $\Delta f_1$ ergibt sich mit den entsprechenden Zahlenwerten

$$\Delta f_1 = 70 kHz + 0.15^* 920 kHz = 208 kHz.$$

Nun sei der Demodulator-Steuerstrom $I_{con}$ proportional zum internen Kondensator $C_{int}$. Dadurch verändert sich der zweite Term auf der rechten Seite von Gleichung (11) und der Synchronisier-Bereich $\Delta f_1$ wird zu

$$\Delta f_1 \geq \Delta f_s + df_1^* f_c \qquad (11a)$$

wobei $df_1$ einen Frequenz-Offset darstellt, der seine Ursache in dem unterschiedlichen Verhalten zwischen dem FM-Demodulator 23 und den den Demodulator-Steuerstrom $I_{con}$ erzeugenden Bauelementen hat, betreffend thermische Drift und parasitäre Effekte. Der maximale Wert von $df_1$ ist etwa 5%. Die obengenannten Zahlenwerte ändern sich dann in

$$\Delta f_1 = 70 kHz + 0.05^* 920 kHz = 116 kHz.$$

Wenn nun zusätzlich die automatische Abgleichschleife in Funktion ist, verliert $df_1$ seine Bedeutung und wird in Gleichung (11a) zu Null, und der Zahlenwert für $\Delta f_1$ ändert sich in $\Delta f_1 = 70 kHz$.

2. Kalibrier-Mode

Die AFT-Schaltung kann kalibriert werden. In Fig. 2 entspricht die Schalterstellung "C" dieser Betriebsart. Dazu wird eine genaue, bekannte Frequenz verwendet. Beispielsweise wird die quarzstabile Frequenz $f_{ch} = 3.579545 MHz$ eines Farboszillators in einem ersten Teiler 22 auf ein fünftel herabgesetzt. Es ergibt sich so die Kalibrier-Frequenz $f_{cal} = 715.909 kHz$. Der Demodulator-Steuerstrom $I_{con}$ wird beispielsweise im ersten 241 und zweiten 242 Multiplizierer um den Faktor k = 0.78 herabgesetzt. Damit wird die kalibrierte Freilauf-Frequenz zu

$$f_{1cal} = 0.78^* f_1 = 717 kHz. \qquad (12)$$

Aufgrund des Frequenz-Offsets

$$\Delta F = f_{mea} - f_{cal} \qquad (13)$$

zwischen der Kalibrier-Frequenz $f_{cal}$ (715.909kHz) und einer AFT-Meßfrequenz $f_{mea}$, wird einem zweiten Transkonduktanzverstärker T2 an seinem Eingang 252 eine Kompensationsspannung $V_{ref} - V_{of}$ zugeführt. $V_{of}$ ergibt sich entsprechend Gleichung (5) zu

$$V_{of} = \Delta F^* k_f. \qquad (14)$$

Der zweite Transkonduktanzverstärker T2 liefert einen maximalen Ausgangsstrom von z.B. ±300μA bei einer Transkonduktanz $k_2$ und lädt den Speicherkondensator 26 ($C_{stor}$) so, daß für die korrigierte, kalibrierte Freilauf-Frequenz gilt:

$$f'_{1cal} = f_{1cal} + V_{of}^* k_f \qquad (15)$$

Ähnlich Gleichung (10) gilt dann

$$f'_{1cal} = k_d/(C_{nom} \pm \Delta C)^* \{I_{conO} - k_3^* k_2^* [k_f^* (f_{1cal-fcal}) - V_{of}]/(p^* C_{stor})\} \qquad (16)$$

Der theoretische Frequenz-Fehlabgleich aufgrund des unterschiedlichen Verhaltens zwischen FM-Demodulator 23 und den den Demodulator-Steuerstrom $I_{con}$ erzeugenden Bauelementen ergibt sich zu

$$f_{1cal} + \Delta F - f_{cal} = df_{1cal}^* f_{cal} \qquad (17)$$

$$= 0.05^* 717 kHz = 35.9 \ kHz$$ und wird vorteilhaft wie im Normal-Mode durch die automatische Abstimmung eliminiert. Einem Zwischenfrequenz-Eingang 24 wird eine Zwischenfrequenz $f_{IF} = 45.75 MHz$ zugeführt, die in einem nachfolgenden zweiten Teiler 223 z.B. um den Faktor n = 16 herabgesetzt wird. Diese herabgesetzte Frequenz wird im Mischer 221 mit der Farboszillator-Frequenz $f_{ch}$ gemischt, wodurch am Eingang des FM-Demodulators 23 eine Meßfrequenz

$$f_{mea} = f_{IF}/16 - f_{ch} \qquad (18)$$

anliegt. Wenn beispielsweise $f_{mea} = 45.75 MHz/16 - 3.579545 MHz = 720.17 kHz$ und $k_f = 20 mV/kHz$, ergibt sich $\Delta F = 4.261 \ kHz$ und $V_{of} = 85 \ mV$.

Die Grenzfrequenz der Abgleichschleife ist um den Faktor $k_2/k_1 = 300 μA/0.5 μA = 600$ mal höher als im Normal-Mode und ergibt sich zu etwa 10kHz. Dies erlaubt eine vorteilhaft kurze Kalibrationszeit von $t_{cal} < 10/f_{1cal} \simeq 1 ms$.

3. Meß-Mode

Bevor die AFT-Schaltung im Meß-Mode arbeiten kann, muß sie wie unter 2.) beschrieben kalibriert werden.

In Fig. 2 entspricht die Schalterstellung "M" der Betriebsart "Meß-Mode". Die Signalquelle im Meß-Mode ist entweder ein Zwischenfrequenz-VCO (voltage controlled oscillator) oder ein verstärktes und begrenztes Zwischenfrequenz-Signal am Zwischenfrequenz-Eingang 24. Die Frequenz $f_{IF}$ dieses Zwischenfrequenz-Signals wird im zweiten Teiler 223 um den Teiler-Faktor n, z.B. n = 16, herabgesetzt und im Mischer 221 mit der Farboszillator-Frequenz $f_{ch}$ gemischt, wodurch am Eingang des FM-Demodulators 23 wie im Kalibrier-Mode eine Meßfrequenz $f_{mea} = f_{IF}/16 - f_{ch}$ anliegt.

Für $f_{IF}$ = 45.75MHz, n = 16 und $f_{ch}$ = 3.579545MHz ist wieder $f_{mea}$ = 720.17kHz.

Der Steuerstrom $I_{conO}$ und damit die Freilauf-Frequenz $f_{1mea}$ des internen Oszillators des FM-Demodulators 23 wird wie im Kalibrier-Mode mit k = 0.78 multipliziert.

Weil die automatische Abgleich-Schleife im Meß-Mode offen ist, bleibt die Speicherspannung $V_c$ konstant und $f_{1mea}$ ist gleich $f'_{1cal}$, z.B. wie in Gleichung (16). Die im Abschnitt 2.) genannte Kompensationsspannung $V_{of}$ wurde so gewählt, daß im Meß-Mode die nominale Meßfrequenz $f_{meanom}$ aus dem von der Zwischenfrequenz $f_{IF}$ abgeleiteten Signal gleich $f_{1cal}$ ist. Die Ausgangsspannung $V_1$ wird zusätzlich einem ersten Komparator CL und einem zweiten Komparator CH zugeführt. Der erste Komparator erhält zusätzlich an seinem Eingang 254 die Spannung $V_{ref} - V_{th}$ und der zweite Komparator an seinem Eingang 253 die Spannung $V_{ref} + V_{th}$, wobei $V_{th}$ eine Schwellspannung ist. Die beiden Komparatoren CL und CH mit der Schwellspannung $V_{th}$ detektieren, ob $f_{mea}$ den korrekten Wert hat ($f_{mea} = f_{meanom}$) oder zu hoch oder zu niedrig ist.

Wenn wie im Kalibrier-Mode die Steilheit der Demodulator-Kennlinie $k_f$ = 20mV/kHz ist, wird als Schwellspannung vorteilhaft gewählt $V_{th} = k_f * 1kHz$ = 20mV.

Dies bewirkt einen Pegelsprung der Ausgangssignale der Komparatoren, falls $|f_{meanom} - f_{mea}| \geq 1kHz$. Die daraus resultierende Fehlabstimmung der Zwischenfrequenz ist $\Delta f_{IF} = n * V_{th}/k_f$, was im obengenannten Beispiel $\Delta f_{IF}$ = 16kHz ergibt.

Wenn der FM-Demodulator 23 für einen Synchronisier-Bereich mit dem Betrag $\Delta f_1$ ausgelegt wird, kann die AFT-Schaltung eine ZF-Fehlabstimmung bis zu $n * \Delta f_1$ ausregeln.

Beispielsweise ist für n = 16 $\Delta f_1$ = 100kHz ein vorteilhafter Wert.

Vorteilhaft hat in Fig. 2 die Referenzspannung $V_{ref}$ den halben Wert der Betriebsspannung $V_{cc}$ der integrierten Schaltung.

Statt der dem Mischer 221 und dem ersten Teiler 22 zugeführten Frequenz $f_{ch}$ können auch Frequenzen von einer anderen quarzstabilen Quelle verwendet werden, die dem Mischer zugeführt werden und das Ausgangssignal des ersten Teilers ersetzen.

Für andere Eingangsfrequenzen an den Eingängen 20 und 24 ergeben sich entsprechend geänderte Frequenzen am Ausgang des Filters 222 und des ersten Teilers 22, ein entsprechend geänderter Wert für den Faktor k und ein geänderter Teilerfaktor des ersten Teilers 22. Beispielsweise für eine Fernsehnorm mit CCIR-Standard B/G ergeben sich folgende Werte:

Frequenz am Eingang 223 des Mischers 221: 5.875 MHz

$f_{IF}$
= 38.9MHz

$f_{meanom}$
= 38.9MHz/16 - 2.9375MHz = 506kHz

$f_{cal}$
= 500kHz

$\Delta F$
= 6kHz

$V_{of}$
= 6kHz * $K_f$ = 120mV

k im Normal-Mode
: 1.00

k sonst
: 1.01

In Fig. 3 wird ein Ausschnitt aus einem integrierten Schaltkreis wiedergegeben, in dem eine Tondemodulation mit Hilfe der erfindungsgemäßen AFT-Schaltung dargestellt ist (nur Normal-Mode).

Ein Konverter 38 erhält an seinem Eingang ein ZF-Signal und führt das gefilterte Ausgangssignal, z.B. ein 4.5/5.5/6.0MHz- oder 6.5MHz-Ton-ZF-Signal, einem ersten Eingang eines ersten Mischers 321 zu. Dieser Mischer kann dem Mischer 221 in Fig. 2 entsprechen. An seinem zweiten Eingang erhält der erste Mischer 321 das Ausgangssignal einer VCO-Schaltung 372, die eine geeignete Mischfrequenz bereitstellt. Dieses Ausgangssignal wird über einen Frequenzteiler 373 zu einem ersten Eingang eines zweiten Mischers 374 weitergeleitet, der an seinem zweiten Eingang ein Signal aus einem Referenzoszillator 371 erhält. Das Ausgangssignal des zweiten Mischers 374 wird über ein Schleifenfilter 375 der VCO-Schaltung 372 zugeführt, womit eine Regelschleife geschlossen ist. Diese Regelschleife führt die Funktion der in Fig. 2 beschriebenen automatischen Abgleichschleife aus.

Das Ausgangssignal des ersten Mischers 321 gelangt zu einem Filter 322, dessen Funktion dem des Filters 222 in Fig. 2 entspricht. Das gefilterte Signal wird dann über einen Begrenzer 391 einem FM-Demodulator 33 zugeführt. Dieser FM-Demodulator entspricht dem FM-Demodulator 23 in Fig. 2.

Die Ausgangssignale des FM-Demodulators 33 werden anschließend in einem ersten Tiefpaßfilter 393 und in einem zweiten Tiefpaßfilter 392 bandbegrenzt. Am Ausgang des ersten Tiefpaßfilters ist ein Audiosignal abgreifbar und am Ausgang des zweiten Tiefpaßfilters eine Regelspannung, die zur Feinabstimmung dem FM-Demodulator 33 und dem Filter 322 zugeführt wird. Die Grenzfrequenz im ersten Tiefpaßfilter liegt z.B. bei 100kHz und im zweiten Tiefpaßfilter z.B. bei 20Hz. Ein zum zweiten Tiefpaßfilter 392 gehörender Kondensator kann auch extern an den integrierten Schaltkreis anschließbar sein.

Im Fall von Stereo- oder Zweiton-Audiosignalen, z.B. beim Zweitonträger-Verfahren, sind das Filter 322, der Begrenzer 391, der FM-Demodulator 33, das erste Tiefpaßfilter 393 und das zweite Tiefpaßfilter 392 entsprechend doppelt vorhanden.

## Patentansprüche

1. Verfahren für eine automatische, hochpräzise Frequenz-Feinabstimmung, **dadurch gekennzeichnet,** daß für einen Abgleich einer frequenzabgleichbaren Analog-Schaltung (23, 33) in einem integrierten Schaltkreis in Abhängigkeit von einer hochpräzisen Bezugsfrequenz ($f_{ch}$) mindestens eine Regelgröße ($I_{con}$) gebildet und gespeichert wird, deren Wert ebenfalls von einem Referenz-Schaltungsteil ($C_{int}$) in dem integrierten Schaltkreis beeinflußt wird, und daß für die Feinabstimmung nacheinander verschiedene Betriebsarten (C, M, N) eingeschaltet werden.

2. Verfahren nach Anspruch 1, **dadurch gekennzeichnet**, daß drei Betriebsarten (C, M, N) vorgesehen sind.

3. Verfahren nach Anspruch 2, **dadurch gekennzeichnet,** daß die Betriebsarten Kalibrier-Mode (C), Meß-Mode (M) und Normal-Mode (N) vorgesehen sind, wobei im Kalibrier-Mode die Bezugsfrequenz ($f_{ch}$) oder eine von der Bezugsfrequenz abgeleitete Frequenz ($f_{cal}$) zum Abgleich der Analog-Schaltung (23, 33) verwendet wird und unter Beibehaltung dieses Abgleichs im Meß-Mode die Feinabstimmung unter Verwendung der zuvor abgeglichenen Analog-Schaltung durchgeführt wird, und wobei im Normal-Mode die Analog-Schaltung entsprechend ihrer bekannten Aufgabe verwendet wird.

4. Verfahren nach einem oder mehreren der Ansprüche 1 bis 3, **dadurch gekennzeichnet,** daß bei einer erstmaligen Abstimmung auf die feinabzustimmende Frequenz oder bei einer Abstimmung auf eine geänderte feinabzustimmende Frequenz mindestens einmal nacheinander Kalibrier-Mode (C), Meß-Mode (M) und Normal-Mode (N) eingeschaltet werden.

5. Verfahren nach einem oder mehreren der Ansprüche 1 bis 4, **dadurch gekennzeichnet,** daß die Regelgrößen Steuerströme ($I_{conO}$, $I_{cor}$, $I_{con}$) sind.

6. Verfahren nach einem oder mehreren der Ansprüche 1 bis 5, **dadurch gekennzeichnet**, daß der Referenz-Schaltungsteil ein Kondensator ($C_{int}$) ist.

7. Verfahren nach einem oder mehreren der Ansprüche 1 bis 6, **dadurch gekennzeichnet,** daß die frequenzabgleichbare Analog-Schaltung ein FM-Demodulator (23, 33) mit einem internen, stromgesteuerten Oszillator oder ein stromgesteuerter Frequenzgenerator ist.

8. Schaltung für ein Verfahren nach einem oder mehreren der Ansprüche 1 bis 7 versehen mit einer mit einer Regelgröße ($I_{con}$) frequenzabgleichbaren Analog-Schaltung (23, 33), mit einem Einspeisepunkt für eine hochpräzise Bezugsfrequenz ($f_{ch}$), mit einem ersten, zweiten und dritten Umschalter, mit einem ersten (T1), zweiten (T2) und dritten (T3) Regelverstärker, mit einem ersten (CL) und einem zweiten (CH) Komparator, mit einem Summierer (21) und mit einem internen Kondensator ($C_{int}$), wobei zugeführt wird:

    - eine Ausgangsspannung ($V_1$) der Analog-Schaltung (23) zweiten Eingängen des ersten (T1) und zweiten (T2) Regelverstärkers und des ersten (CL) und zweiten (CH) Komparators;
    - eine Referenzspannung ($V_{ref}$) einem ersten Eingang (251) des ersten Regelverstärkers (T1) in einem Normal-Mode;
    - eine kombinierte Spannung aus der Referenzspannung ($V_{ref}$) und einer Kompensationsspannung ($V_{of}$) einem ersten Eingang (252) des zweiten Regelverstärkers (T2) in einem Kalibrier-Mode;
    - eine Differenzspannung aus der Referenzspannung ($V_{ref}$) und einer Schwellspannung ($V_{th}$) einem ersten Eingang (254) des ersten Komparators (CL) und eine Summenspannung aus der Referenzspannung ($V_{ref}$) und der Schwellspannung ($V_{th}$) einem ersten Eingang (253) des zweiten Komparators (CH) in einem Meß-Mode;
    - ein Ausgangssignal des ersten Regelverstärkers (T1) einem ersten Eingang (N)

des dritten Umschalters im Normal-Mode;

- ein Ausgangssignal des zweiten Regelverstärkers (T2) einem dritten Eingang (C) des dritten Umschalters im Kalibrier-Mode;
- ein Ausgangssignal des dritten Umschalters einem Eingang des dritten (T3) Regelverstärkers;
- ein Ausgangssignal des dritten (T3) Regelverstärkers einem ersten Eingang des Summierers (21);
- ein von der Größe des internen Konden-sators ($C_{int}$) abgeleitetes und mit einem Faktor (k) umgeformtes Signal einem zweiten Eingang des Summierers (21);
- ein Ausgangssignal des Summierers (21) einem Steuereingang der Analog-Schaltung (23);
- ein in der Analog-Schaltung (23) zu ver-arbeitendes Nutzsignal einem ersten Ein-gang (N) des ersten Umschalters im Normal-Mode;
- eine Zusatzsignal-Frequenz einem zweiten Eingang (C, M) des ersten Umschalters im Kalibrier- und im Meß-Mode;
- die Bezugsfrequenz ($f_{ch}$) oder eine davon abgeleitete Frequenz ($f_{cal}$) einem ersten Eingang (C) des zweiten Umschalters im Kalibrier-Mode;
- eine vom Ausgangssignal des ersten Umschalters abgeleitete Signalfrequenz ($f_s$) einem zweiten Eingang (N, M) des zweiten Umschalters;
- ein Ausgangssignal des zweiten Umschalters der Analog-Schaltung (23).

9.  Schaltung nach Anspruch 8, **dadurch gekennzeichnet,** daß der erste, zweite und dritte Regelverstärker Transkonduktanzverstärker und daß die Ausgangssignale dieser Transkonduktanzverstärker und die Signale am ersten und zweiten Eingang des Summierers (21) und das Ausgangssignal des Summierers Ströme sind.

10. Schaltung nach Anspruch 8 oder 9, **dadurch gekennzeichnet**, daß die kombinierte Spannung eine Differenzspannung ist.

11. Schaltung nach einem oder mehreren der Ansprüche 8 bis 10, **dadurch gekennzeichnet,** daß das mit einem Faktor (k) umgeformte Signal ein in einem Multiplizierer (241) mit dem Faktor (k) multipliziertes Signal ist.

FIG.1

FIG.3

FIG.2

EP 0 501 536 A2